# NOUVEAU FASCICULE DE BREVET EUROPEEN

(11) **EP 0 725 767 B2**
(45) Date de publication et mention de la décision concernant l'opposition: **12.05.2004**
(45) Mention de la délivrance du brevet: 10.03.1999
(21) Numéro de dépôt: 94927698.4
(22) Date de dépôt: 20.09.1994
(51) Int. Cl.: C04B 35/83, C04B 35/80

(54) **PROCEDE D'INFILTRATION CHIMIQUE EN PHASE VAPEUR D'UN MATERIAU AU SEIN D'UN SUBSTRAT POREUX A TEMPERATURE DE SURFACE CONTROLEE**
VERFAHREN ZUR CHEMISCHEN DAMPFPHASENINFILTRATION VON MATERIAL INS INNERE EINES PORÖSEN SUBSTRATES MIT KONTROLLIERTER OBERFLÄCHENTEMPERATUR
VAPOR PHASE CHEMICAL INFILTRATION PROCESS OF A MATERIAL INTO A POROUS SUBSTRATE AT CONTROLLED SURFACE TEMPERATURE

(30) Priorité: 27.10.1993 FR 9312807
(43) Date de publication de la demande: 14.08.1996
(73) Titulaire: SOCIETE NATIONALE D'ETUDE ET DE CONSTRUCTION DE MOTEURS D'AVIATION, "S.N.E.C.M.A.", 75015 Paris (FR)
(72) Inventeur: DELPERIER, Bernard, F-33127 Martignas sur Jalles (FR); ROBIN-BROSSE, Christian, F-33185 Le Haillan (FR); DOMBLIDES, Jean-Luc, F-33520 Bruges (FR); BONDIEU, Gilles, F-33127 Saint-Jean-d'Illac (FR)
(74) Mandataire: Joly, Jean-Jacques
(86) Numéro de dépôt international: PCT/FR1994/001090
(87) Numéro de publication internationale: WO 1995/011868

(56) Documents cités:
- FR-A- 2 225 396
- US-A- 3 164 487
- US-A- 5 254 374
- 16TH NATIONAL SAMPE SYMPOSIUM, 21 Avril 1971, ANAHEIM, US pages 257 - 265 W.V. KOTLENSKY 'A review of CVD carbon infiltration of porous substrates' cité dans la demande
- Kotlensky et al,"Deposition of pyrolitic carbon in porous solid", 1973, Vol. 9, PP190 bis 203
- Kotlensky et al, 16th National SAMPE Symposium, April 21st, 1971,p.260

## Description

La présente invention concerne un procédé d'infiltration chimique en phase vapeur d'un matériau au sein d'un substrat poreux.

Le domaine d'application de l'invention est notamment celui de la fabrication de pièces en matériaux composites comprenant un substrat fibreux, ou préforme, densifié par une matrice. Dans cette application, l'infiltration chimique en phase vapeur est employée pour former un dépôt du matériau constitutif de la matrice sur les fibres du substrat, dans tout le volume de celui-ci, afin de lier les fibres entre elles et combler la porosité initiale accessible du substrat. L'infiltration chimique en phase vapeur peut également être utilisée pour compléter une densification partielle réalisée par un autre procédé, par exemple par voie liquide, celle-ci consistant à imprégner le substrat par un précurseur liquide du matériau constitutif de la matrice, puis à transformer le précurseur, généralement par traitement thermique.

Pour réaliser l'infiltration chimique en phase vapeur, le substrat fibreux est placé dans une enceinte. Une phase gazeuse réactionnelle est admise dans l'enceinte. Dans des conditions de température et de pression déterminées, la phase gazeuse diffuse au sein du substrat et forme le dépôt du matériau de la matrice par décomposition ou réaction entre ses constituants au contact des fibres.

La composition de la phase gazeuse est choisie en fonction de la nature de la matrice à réaliser. Les processus d'infiltration chimique en phase vapeur, permettant de former des matrices en carbone pyrolytique, ou pyrocarbone, ou en céramique, par exemple carbure de silicium, nitrure de bore ou oxydes réfractaires, sont bien connus.

Il existe plusieurs types de procédés d'infiltration chimique en phase vapeur : le procédé isotherme-isobare, le procédé à gradient de pression et le procédé à gradient de température.

Dans le procédé isotherme-isobare, le substrat à densifier est placé dans une enceinte isotherme. Le chauffage est assuré par exemple par un suscepteur, ou induit, en graphite qui entoure l'enceinte et est lui-même entouré par un bobinage inducteur. L'apport énergétique au substrat s'effectue essentiellement par rayonnement de l'enceinte sur le substrat. La température à l'intérieur de l'enceinte est régulée à la valeur voulue par commande du courant dans l'inducteur, tandis que la pression est réglée par liaison de l'enceinte avec une source de vide et commande du débit de la phase gazeuse admise dans l'enceinte. Le dépôt du matériau de la matrice s'effectue à l'intérieur du substrat et à la surface de celui-ci. La température et la pression sont choisies à des valeurs seulement légèrement supérieures à celles requises pour la formation du dépôt, afin d'éviter un dépôt massif en surface du substrat, dès le contact avec la phase gazeuse, qui conduirait à l'obturation rapide de la porosité de surface empêchant la densification au sein du substrat.

Toutefois, la fermeture progressive de la porosité de surface est inévitable et bloque le processus de densification avant que celle-ci soit complète au coeur du substrat. Il est alors nécessaire de procéder à un écroûtage de la surface par usinage afin de ré-ouvrir le réseau de porosités et poursuivre la densification. Plusieurs opérations intermédiaires d'écroûtage peuvent être nécessaires sur une même pièce avant d'arriver au niveau de densification souhaité.

Ce procédé, par le contrôle précis des conditions d'infiltration, permet d'obtenir une matrice de la qualité souhaitée, et ce de façon reproductible. Il présente aussi l'avantage important de permettre la densification simultanée de plusieurs pièces de formes diverses dans la même enceinte.

Face à ces avantages, qui justifient son utilisation à l'échelle industrielle, le procédé isotherme-isobare présente les inconvénients d'une durée élevée et d'un coût important, notamment pour la fabrication de pièces composites de forte épaisseur. En effet, la densification requiert des vitesses de dépôt faibles, donc des cycles de durée importante. De plus, les opérations intermédiaires d'usinage pour l'écroûtage provoquent des pertes de matière, qui contribuent à accroître le prix de revient, et l'alternance entre infiltration et écroûtage rallonge la durée totale de fabrication et son coût. Enfin, en particulier pour les pièces de forte épaisseur, un gradient de densification important subsiste inévitablement au sein d'une même pièce, le degré de densification étant sensiblement moins important au coeur de la pièce qu'à sa surface.

Le procédé à gradient de pression utilise un flux forcé de la phase gazeuse à travers la préforme. Cet écoulement forcé se traduit par une différence de pression à travers la pièce.

Outre qu'il nécessite une adaptation particulière du système de transport de la phase gazeuse, le procédé à gradient de pression présente une même limitation que le procédé isotherme-isobare. En effet, la perméabilité des pores à la phase gazeuse décroît rapidement avec formation d'un dépôt plus important du côté de la face d'entrée de la phase gazeuse. Un écroûtage périodique de cette face est nécessaire pour poursuivre la densification.

De plus, ce procédé n'est applicable que pour des configurations de substrat particulièrement simples et limitées et chaque pièce nécessite un dispositif particulier d'alimentation et de circulation de la phase gazeuse.

Le procédé à gradient de température consiste à réaliser un chauffage non uniforme du substrat, de sorte que celui-ci présente, au voisinage de sa surface exposée, une température moins élevée que dans des parties internes éloignées de cette surface. La réaction de dépôt étant thermiquement activée, la vitesse de dépôt, ou croissance de la matrice, augmente avec la température. Il s'ensuit une densification plus importante dans les parties les plus chaudes, au sein du substrat, que dans les parties les moins chaudes, au niveau de la surface exposée du substrat. On évite ainsi la formation d'un dépôt plus important en surface, avec obturation prématurée de la porosité, et la nécessité d'opérations intermédiaires. C'est à ce type de procédé d'infiltration que se rapporte la présente invention.

Un dispositif d'infiltration chimique en phase vapeur avec gradient de température a été présenté et décrit par W. V Kotlensky au "16th National SAMPE Symposium, Anaheim, Califomia, April 21-23, 1971" sous le titre "A Review of CVD Carbon Infiltration of Porous Substrates", p. 257-265 et dans un ouvrage intitulé "Chemistry and Physic of Carbon", édité aux Etats-Unis d'Amérique par P. L. Walker, vol. 9, p. 198-199.

Le substrat à densifier est appliqué par une face interne contre un induit en graphite. Le substrat et l'induit sont logés à l'intérieur d'une enceinte. Une bobine inductrice entoure l'enceinte. La phase gazeuse est admise à la base de l'enceinte et circule de bas en haut.

L'induit est chauffé par couplage électromagnétique avec l'inducteur et chauffe à son tour le substrat avec lequel il est en contact. Un gradient thermique s'établit à travers le substrat entre la face interne au contact de l'induit et la face externe exposée où s'établit une température plus faible en raison des pertes thermiques par radiation et des pertes par convection dues à la circulation de la phase gazeuse.

Le gradient thermique est plus ou moins important en fonction de la conductivité thermique du substrat. Si l'on se reporte à la page 260, 2^{ème} colonne de l'article de W.V. Kotlensky cité en premier plus haut, les températures indiquées sont, pour l'induit environ 1500°C et 1650°C et, pour le gradient, respectivement environ 510°C et 565°C. Il en résulte une température de surface du substrat d'environ 990°C et 1085°C. Cette température est largement supérieure à la température minimale de dépôt de pyrocarbone à partir du méthane ou autres hydrocarbures qui sont les précurseurs de carbone envisagés dans cet article. On note en outre, dans le même passage de cet article, qu'en raison de sa faible densité et du faible couplage avec l'inducteur, le substrat lui-même n'est pas chauffé directement par induction.

Une autre technique d'infiltration chimique en phase vapeur avec gradient de température a été décrite par J. J. Gebhardt et al. dans un article intitulé "Formation of carbon-carbon composite materials by pyrolytic infiltration", Petroleum derived carbons ACS Series N°21 6/73.

Dans ce cas, le substrat à densifier est constitué par des faisceaux de fibres de graphite entrelacés orientés dans 7 directions différentes. Le substrat est suspendu à l'intérieur d'une enceinte à la base de laquelle la phase gazeuse est admise. Les fibres de graphite sont suffisamment conductrices de l'électricité pour permettre le chauffage du substrat par couplage direct avec une bobine inductrice qui entoure l'enceinte.

La zone la plus chaude du substrat est située à l'intérieur de celui-ci, la surface extérieure étant refroidie par radiation et par la circulation de la phase gazeuse de bas en haut dans l'enceinte. Un gradient de température de quelques °C par centimètre est obtenu à partir de la partie interne la plus chaude.

Afin de maintenir un gradient de température suffisant, la phase gazeuse circule à vitesse élevée pour refroidir la surface et la bobine inductrice est limitée à quelques spires pour chauffer une zone limitée du substrat, de sorte qu'un gradient thermique s'établit aussi entre la partie du substrat située dans le champ de l'inducteur et la partie du substrat située hors du champ. La densification de tout le substrat est obtenue en le déplaçant dans l'enceinte, parallèlement à l'axe de la bobine. Ces contraintes font que le procédé ne peut être que d'un usage limité, difficilement industrialisable.

La présente invention a pour but de fournir un procédé d'infiltration chimique en phase vapeur de pyrocarbone au sein d'un substrat poreux dans lequel un gradient thermique a été établi. L'invention a notamment pour but d'améliorer encore l'effet du gradient thermique par lequel le dépôt de pyrocarbone est favorisé dans des parties internes du substrat éloignées des surfaces exposées de celui-ci.

Ce but est atteint grâce à un procédé selon lequel, conformément à l'invention, au début du processus d'infiltration et au moins pendant la plus grande partie de celui-ci, la température d'une surface exposée du substrat est mesurée, et le chauffage du substrat est commandé de manière à réguler la température de la surface exposée pour la maintenir à une valeur au plus égale à la température minimale de formation du matériau à infiltrer à partir de la phase gazeuse réactionnelle, tandis que les parties du substrat éloignées de la surface exposée sont à une température supérieure à la température minimale de formation du matériau

Le chauffage du substrat peut être réalisé par contact entre une surface du substrat et un corps chauffé, de sorte qu'un gradient de température s'établit au sein du substrat entre la surface au contact du corps chauffé et les surfaces exposées. Le corps chauffé peut être constitué par un induit, par exemple en graphite, couplé électromagnétiquement à un inducteur situé à l'extérieur de l'enceinte.

Lorsque le substrat est en matière conductrice de l'électricité, il est envisageable de chauffer le substrat par couplage électromagnétique direct avec un inducteur situé à l'extérieur de l'enceinte.

Lorsque le chauffage est produit par induction, la commande du chauffage est réalisée par commande du courant dans l'inducteur.

Comme indiqué plus haut, lors du processus d'infiltration chimique en phase vapeur, le dépôt du matériau infiltré résulte de la décomposition de la phase gazeuse, ou d'un de ses constituants, ou d'une réaction entre constituants de la phase gazeuse.

Le dépôt est un processus thermiquement activé, la vitesse de dépôt augmentant avec la température.

Pour une phase gazeuse réactionnelle donnée, il existe une température minimale à partir de laquelle le dépôt commence à se produire. Cette température minimale de dépôt peut être fonction de la pression régnant dans l'enceinte.

A titre indicatif, pour le dépôt de pyrocarbone à partir d'une phase gazeuse contenant du propane, la température minimale de dépôt est égale à environ 870°C.

Pour le dépôt de carbure de silicium à partir d'une phase gazeuse comprenant du méthyltrichlorosilane (MTS) et de l'hydrogène, la température minimale de dépôt est égale à environ 700°C.

Le contrôle de la température de surface du substrat de sorte qu'elle ne dépasse pas la température minimale de dépôt favorise la densification au coeur du substrat. En effet, on évite ainsi la formation trop rapide d'un dépôt de surface susceptible d'obturer la porosité et d'empêcher la densification au coeur du substrat. En outre, l'existence du gradient thermique fait que les parties du substrat éloignées de ses surfaces exposées sont à une température plus élevée que la température minimale de dépôt de sorte que le dépôt se produit préférentiellement au coeur du substrat.

Au cours du processus d'infiltration, la densification du substrat progresse en direction de ses surfaces exposées. Vers la fin du processus de densification, le risque d'un empêchement de la densification au coeur du substrat par obturation prématurée de la porosité de surface est atténué. C'est pourquoi il est envisageable de maintenir la surface du substrat à une valeur au plus égale à la température minimale de dépôt seulement au début du processus d'infiltration et pendant la plus grande partie de celui-ci, et de terminer la densification en portant la température de surface du substrat à une valeur légèrement supérieure à celle de la température minimale de dépôt.

Des exemples de mise en oeuvre du procédé conforme à l'invention seront maintenant décrits, à titre indicatif mais non limitatif.

On se référera aux dessins annexés sur lesquels :
- la figure 1 est une vue très schématique d'une installation permettant la mise en oeuvre du procédé conforme à l'invention,
- la figure 2 montre l'évolution du gradient de température et du gradient de densité au sein d'une pièce densifiée par un procédé conforme à l'invention, et
- la figure 3 est une vue très schématique partielle illustrant une variante de mise en oeuvre du procédé conforme à l'invention.

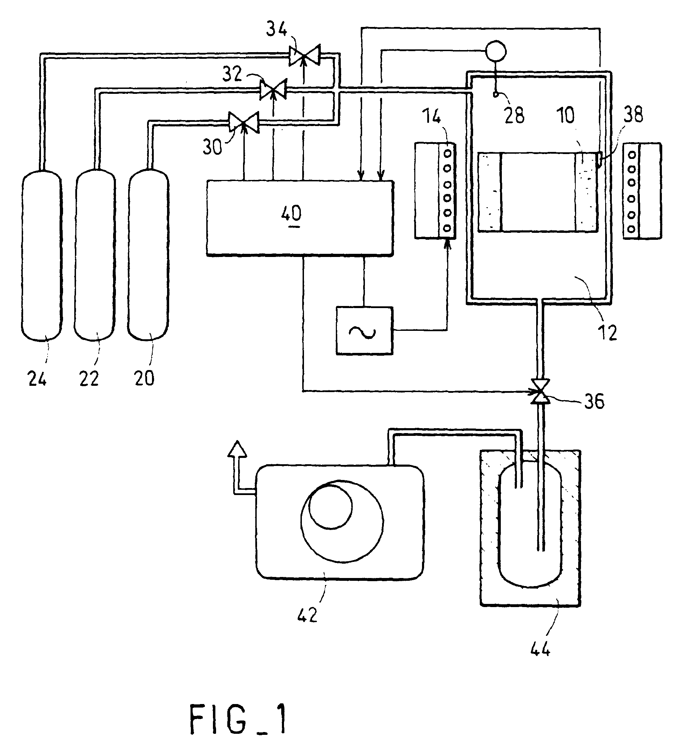

Dans l'installation de la figure 1, un substrat à densifier 10 est logé à l'intérieur d'une enceinte 12. Dans cet exemple, le substrat 10 est une structure fibreuse de forme cylindrique annulaire à section méridienne rectangulaire. Le chauffage du substrat est assuré par couplage électromagnétique direct avec une bobine inductrice 14 qui entoure l'enceinte. Le substrat 10 et la bobine 14 sont coaxiaux.

La bobine 14 s'étend axialement sur une longueur égale ou supérieure à celle du substrat 10 de sorte que celui-ci se trouve entièrement à l'intérieur du champ électromagnétique engendré par la bobine 14.

La phase gazeuse propre à former le dépôt souhaité sur les fibres du substrat 10 est admise à la partie supérieure de l'enceinte 12. La phase gazeuse comprend par exemple un mélange de plusieurs gaz issus de sources respectives, telles que les sources 20, 22, 24, à travers des vannes d'injection respectives 30, 32,34.

Lors du processus d'infiltration chimique en phase vapeur, les produits de réaction gazeux, y compris le reliquat de phase gazeuse réactionnelle, sont extraits à la partie inférieure de l'enceinte 12. L'extraction est réalisée par ouverture d'une vanne 36 qui met la chambre en communication avec une pompe à vide 42 à travers un piège à azote liquide 44 permettant de retenir les espèces gazeuses indésirables et d'éviter leur rejet dans le milieu ambiant.

Les vannes 30, 32, 34, 36 sont commandées par un automate 40. L'automate reçoit un signal produit par un capteur 28 et représentatif de la pression dans l'enceinte 12 et commande la vanne 36 pour que règne une pression déterminée dans l'enceinte 12 avant admission de la phase gazeuse.

L'automate 40 reçoit en outre un signal fourni par un capteur 38 représentatif de la température du substrat 10 au niveau d'une de ses surfaces exposées au flux gazeux circulant dans l'enceinte. Le capteur 38 est par exemple un thermocouple disposé au contact de la surface périphérique du substrat 10.

L'automate 40 commande le courant dans l'inducteur 14 afin de maintenir la température de la surface exposée du substrat à une valeur au plus égale à la valeur de la température minimale à partir de laquelle un dépôt est produit par la phase gazeuse. Cette valeur minimale peut être fonction de la pression dans l'enceinte. L'automate 40 est alors avantageusement programmé pour déterminer la valeur de consigne de température de surface du substrat en fonction de la pression mesurée au moyen du capteur 28, et de la nature de la phase gazeuse. De préférence, la température T_{S} de surface exposée du substrat est régulée à une valeur telle que T_{D}- 50°C ≤ T_{S} ≤ T_{D}, où T_{D} est la température minimale de dépôt.

Le substrat 10 est en fibres conductrices de l'électricité. Il présente des caractéristiques de résistivité électrique et de conductivité thermique qui le rendent apte à être chauffé par couplage direct avec la bobine 14.

Un type de structure convenant particulièrement pour le substrat 10 est une structure en fibres de carbone ou graphite aiguilletée.

Un procédé de réalisation d'une telle structure tridimensionnelle est décrit dans le document FR-A-2 584107. Les caractéristiques souhaitables de résistivité électrique et de conductivité thermique sont données dans la demande de brevet déposée par la demanderesse le même jour que la présente demande, sous le titre "Procédé d'infiltration chimique en phase vapeur d'un matériau au sein d'un substrat fibreux avec établissement d'un gradient de température dans celui-ci" et à laquelle il est fait expressément référence. En résumé, la résistivité électrique radiale est comprise de préférence entre 1 et 20mΩ/cm et le rapport entre résistivité électrique radiale et résistivité électrique circonférentielle est de préférence au moins égal à 1,3, tandis que la conductivité thermique radiale est comprise de préférence entre 0,1 et 20 W/m.°K et que le rapport entre conductivité thermique radiale et conductivité thermique circonférentielle est de préférence au plus égal à 0,9. Ces caractéristiques peuvent être atteintes avec un taux volumique de fibres, c'est-à-dire le pourcentage du volume apparent du substrat effectivement occupé par les fibres égal à au moins 20 %.

Le chauffage du substrat par induction est produit par effet Joule, par les courants induits. Il est bien connu que ceux-ci se concentrent en surface (effet de peau). Ce phénomène de concentration en surface est d'autant plus marqué que la fréquence du courant alimentant l'inducteur est élevée.

En dépit de l'effet de peau, par le choix d'une fréquence convenable et en tenant compte du refroidissement en surface du substrat par radiation et convection (écoulement de la phase gazeuse), il est possible d'obtenir un gradient de température au sein du substrat.

A l'évidence, la fréquence la mieux adaptée dépend de plusieurs paramètres : nature des fibres constituant le substrat, épaisseur de celui-ci, valeurs de résistivité électrique et conductivité thermique, ...

A titre indicatif, pour un substrat aiguilleté en fibres de carbone obtenu comme décrit ci-dessus, la fréquence optimale se trouve dans la gamme d'environ 100 Hz à environ 3000 Hz, selon le taux de fibres et l'épaisseur du substrat.

Dans l'exemple illustré par la figure 1, le substrat 10 a une forme cylindrique à section droite circulaire. Le procédé selon l'invention peut être mis en oeuvre avec des substrats ayant d'autres formes, notamment des substrats cylindriques à section non circulaire ou des substrats axi-symétriques non cylindriques, en adaptant, le cas échéant, la forme de l'inducteur.

### Exemple

Une pièce en matériau composite carbone-carbone ayant une forme cylindrique annulaire de diamètre extérieur 1100 mm, d'épaisseur 130 mm et de hauteur 100 mm, destinée à un col de tuyère de propulseur est réalisée comme suit :

Un substrat fibreux, ou préforme, ayant des dimensions correspondant à celles de la pièce à réaliser est fabriqué à partir d'une texture bidimensionnelle constituée par un tissu de fibres de polyacrylonitrile (PAN) préoxydé, précurseur du carbone. Le tissu est bobiné en couches superposées sur un mandrin dont le diamètre correspond au diamètre intérieur de la préforme.

Chaque nouvelle couche est aiguilletée sur la texture sous-jacente. On utilise à cet effet une planche à aiguilles qui s'étend axialement sur une distance au moins égale à la largeur des strates, celle-ci étant égale à la hauteur (100 mm) de la préforme à réaliser. L'aiguilletage est réalisé au fur et à mesure du bobinage, chaque nouvelle couche étant aiguilletée à une profondeur constante égale à l'épaisseur de plusieurs couches aiguilletées. Lorsque l'épaisseur désirée de la préforme a été atteinte, dans cet exemple 130 mm, une ou plusieurs passes d'aiguilletage de finition sont réalisées, de façon connue en soi, pour obtenir une densité d'aiguilletage constante dans toute la préforme. L'aiguilletage est réalisé avec une densité permettant d'aboutir à un taux volumique de fibres égal à 28 % dans la préforme, après traitement thermique transformant le PAN préoxydé en carbone. On notera que, comme bien connu en soi, l'aiguilletage est réalisé sur les fibres à l'état de précurseur du carbone, l'effet de l'aiguilletage directement sur des fibres de carbone étant trop destructeur.

La préforme est densifiée par une matrice pyrocarbone au moyen d'une installation telle que montrée par la figure 1. La matrice pyrocarbone est obtenue à partir d'une phase gazeuse comprenant un mélange de méthane et de propane. La température minimale de dépôt T_{D}, dans ce cas la température de décomposition commençante du propane, est égale à 870°C pour une pression dans l'enceinte 12 de 11 torrs.

La préforme est chauffée par couplage électromagnétique direct avec l'inducteur 14, ce dernier étant alimenté par un courant de fréquence égale à 150 Hz. Au moins pendant la première phase de densification, l'intensité du courant est commandée de manière à maintenir la température T_{S} de la surface externe de la préforme à une valeur telle que 820°C ≤ T_{S} ≤ 870°C.

Au départ, l'intensité du courant est commandée de manière à maintenir la température de paroi de la surface externe de la préforme à une valeur d'environ 830°C.

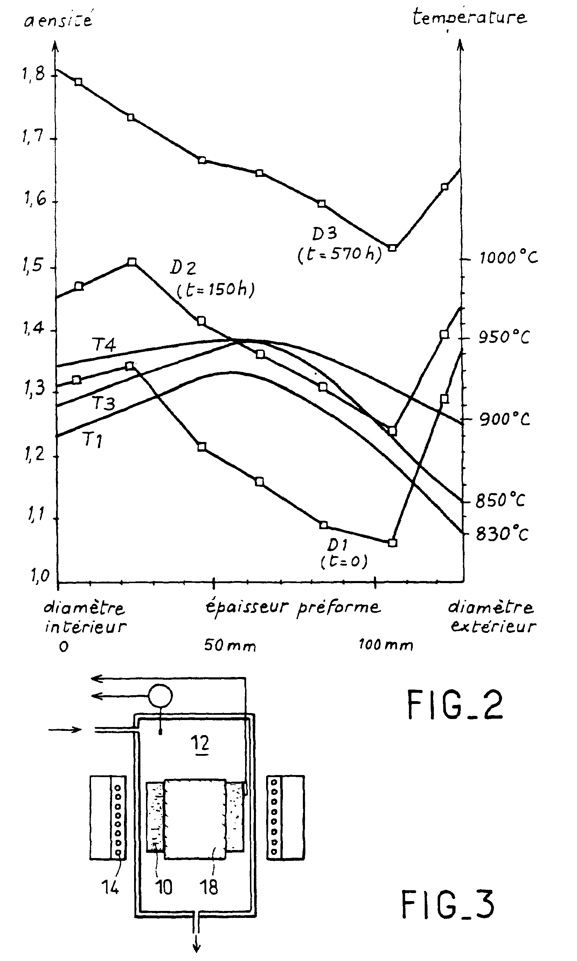

La répartition de la température dans l'épaisseur de la préforme (en direction radiale) est mesurée au début de la densification (temps t1 = 0) ainsi que la répartition de densité (en direction radiale) initiale que présente cette préforme (courbe T1 fig. 2, et courbe D1 fig. 2).

Une densification partielle est alors réalisée en régulant la température de paroi externe entre à la valeur de départ durant un temps t2 de 150 h. La répartition de densité obtenue est donnée par la courbe D2.

La densification est alors poursuivie en appliquant le profil de température T3 (figure 2) en maintenant la température de paroi externe (côté diamètre extérieur) à une valeur évoluant de 850 à 900° C. Après 400 h de densification, le profil T4 est obtenu, et la répartition de densité D3 est mesurée. Une densité moyenne de 1.65 est mesurée sur la pièce composite.

Le procédé conforme à l'invention permet d'aboutir à une densification presque uniforme sans opération d'usinage intermédiaire. La densité moyenne de la pièce composite obtenue est égale à 1,65.

Dans l'exemple qui précède, il est envisagé de former la matrice pyrocarbone à partir d'une phase gazeuse comprenant un mélange de méthane ou de propane. De façon plus générale, le précurseur de carbone dans la phase gazeuse pourra être constitué par au moins un hydrocarbure saturé tel qu'un alcane, un alcène, un alcyne, un alkyle, ou un mélange de ceux-ci.

Par ailleurs, il est avantageux d'utiliser une phase gazeuse comprenant de l'hydrogène, en combinaison avec le précurseur gazeux du pyrocarbone.

En effet, comme décrit dans la demande de brevet du même jour que la présente demande déposée par la demanderesse sous l'intitulé "Procédé d'infiltration chimique en phase vapeur d'une matrice pyrocarbone au sein d'un substrat poreux avec établissement d'un gradient de température dans le substrat", l'hydrogène présente la propriété d'inhiber la réaction de dépôt du pyrocarbone pour une température inférieure à environ 1230°C, et de l'activer pour une température supérieure à environ 1230°C. On établit alors au sein du substrat un gradient thermique tel que la température des parties internes les plus chaudes du substrat soit supérieure à 1230°C tandis que la température des parties substrat proches des surfaces exposées est inférieure à 1230°C. L'effet du gradient thermique sur la vitesse de dépôt du pyrocarbone se trouve alors amplifié par l'hydrogène au coeur du substrat et atténué au voisinage des surfaces exposées. L'hydrogène contribue ainsi à favoriser une densification uniforme.

Une variante de mise en oeuvre du procédé selon l'invention est illustrée par la figure 3 qui est une vue partielle d'une installation d'infiltration chimique en phase vapeur. Les éléments communs aux modes de réalisation des figures 1 et 3 portent les mêmes références et ne seront pas à nouveau décrits.

Le mode de réalisation de la figure 3 se distingue de celui de la figure 1 par le fait que le chauffage du substrat 10 est réalisé non pas par couplage direct avec l'inducteur 14, mais par contact avec un induit massif en graphite 18 sur lequel le substrat annulaire 10 est engagé.

Le couplage électromagnétique se produit essentiellement entre l'inducteur 14 et l'induit 18. Un gradient de température est établi au sein du substrat 10 entre la surface interne la plus chaude au contact de l'induit 18 et la surface externe exposée la moins chaude dont la température est contrôlée.

Ce mode de réalisation convient plus particulièrement dans le cas de substrats qui, par nature, ont des caractéristiques telles qu'un chauffage par induction directe n'est pas ensivageable.

## Revendications

1. Procédé pour l'infiltration chimique en phase vapeur d'un matériau au sein d'un substrat poreux, le procédé comprenant les étapes qui consistent à :
- placer le substrat dans une enceinte avec une surface du substrat au contact d'un induit,
- chauffer le substrat par circulation d'un courant dans un inducteur couplé électromagnétiquement avec l'induit, de sorte qu'un gradient thermique est établi au sein du substrat entre sa surface au contact de l'induit et une surface exposée, et
- admettre dans l'enceinte une phase gazeuse réactionnelle précurseur du matériau à infiltrer, la formation du matériau étant favorisée dans les parties du substrat de température plus élevée,
**caractérisé en ce que** :
- la température d'une surface exposée du substrat est mesurée, et
- au début du processus d'infiltration et pendant au moins la plus grande partie de celui-ci, le courant dans l'inducteur est commandé de manière à réguler la température de la surface exposée du substrat pour la maintenir à une valeur au plus égale à la température minimale de formation du matériau à infiltrer à partir de la phase gazeuse réactionnelle, tandis que les parties du substrat éloignées de la surface exposée sont à une température supérieure à la température minimale de formation du matériau.

2. Procédé selon la revendication 1, **caractérisé en ce que** la température de surface exposée du substrat T_{S} est maintenue à une valeur telle que
T_{D} - 50°C ≤ T_{S} ≤ T_{D}, où T_{D} est la température minimale de formation du matériau.

3. Procédé selon l'une quelconque des revendications 1 et 2, pour l'infiltration chimique en phase vapeur de pyrocarbone à partir d'une phase gazeuse réactionnelle contenant au moins un hydrocarbure saturé ou insaturé, **caractérisé en ce que** l'on admet dans l'enceinte une phase gazeuse réactionnelle contenant en outre de l'hydrogène et l'on établit au sein du substrat un gradient thermique de part et d'autre d'une température de 1230°C.

4. Procédé pour l'infiltration chimique en phase vapeur d'un matériau au sein d'un substrat poreux, le procédé comprenant les étapes qui consistent à :
- placer le substrat dans une enceinte,
- chauffer le substrat en établissant un gradient thermique au sein du substrat de sorte que le substrat présente une température plus élevée dans des parties éloignées de surfaces exposées qu'au niveau de celles-ci, et
- admettre dans l'enceinte une phase gazeuse réactionnelle précurseur du matériau à infiltrer, la formation du matériau étant favorisée dans les parties du substrat de température plus élevée,
**caractérisé en ce que** :
- on utilise un substrat en une matière conductrice de l'électricité,
- on chauffe le substrat par couplage électromagnétique direct entre le substrat et un inducteur,
- la température d'une surface exposée du substrat est mesurée, et
- au début du processus d'infiltration et pendant au moins la plus grande partie de celui-ci, on commande un courant dans l'inducteur de manière à réguler la température d'une surface exposée du substrat pour la maintenir à une valeur au plus égale à la température minimale de formation du matériau à infiltrer à partir de la phase gazeuse réactionnelle, tandis que les parties du substrat éloignées de la surface exposée sont à une température supérieure à la température minimale de formation du matériau.

5. Procédé selon la revendication 4, **caractérisé en ce que** la température de surface exposée du substrat T_{S} est maintenue à une valeur telle que
T_{D} - 50°C ≤ T_{S} ≤ T_{D}, où T_{D} est la température minimale de formation du matériau.

6. Procédé selon l'une quelconque des revendications 4 et 5, pour l'infiltration chimique en phase vapeur de pyrocarbone à partir d'une phase gazeuse réactionnelle contenant au moins un hydrocarbure saturé ou insaturé, **caractérisé en ce que** l'on admet dans l'enceinte une phase gazeuse réactionnelle contenant en outre de l'hydrogène et l'on établit au sein du substrat un gradient thermique de part et d'autre d'une température de 1230°C.

7. Procédé selon l'une quelconque des revendications 4 à 6, **caractérisé en ce que** l'on utilise un substrat en fibres de carbone ou de graphite aiguilleté.

8. Procédé selon la revendication 7, **caractérisé en ce que** l'on fait circuler dans l'inducteur un courant de fréquence comprise entre 100 Hz et 3 000 Hz.

## Patentansprüche

1. Verfahren zum chemischen Infiltrieren von Material in das Innere eines porösen Substrats aus der Dampfphase, umfassend folgende Schritte:
- Anordnen des Substrats in einer Kammer, wobei eine Fläche des Substrats mit einem Anker in Kontakt steht,
- Erhitzen des Substrats durch Stromfluß in einem elektromagnetisch mit dem Anker gekoppelten Induktor derart, daß im Inneren des Substrats zwischen dessen mit dem Anker in Kontakt stehender Fläche und einer freiliegenden Fläche ein Wärmegradient gebildet wird, und
- Einleiten eines Reaktions-Gasphasen-Vorläufers des zu infiltrierenden Materials in die Kammer, wobei die Bildung des Materials in den Bereichen des Substrats, in denen eine höhere Temperatur herrscht, begünstigt wird,
**dadurch gekennzeichnet, daß**
- die Temperatur einer freiliegenden Fläche des Substrats gemessen wird, und
- am Anfang des Infiltrationsprozesses und während zumindest des überwiegenden Teils des Prozesses der Stromfluß in dem Induktor in der Weise gesteuert wird, daß die Temperatur der freiliegenden Fläche des Substrats geregelt wird, um sie auf einem Wert zu halten, der höchstens gleich ist der kleinsten Ausbildungstemperatur des aus der Reaktions-Gasphase zu infiltrierenden Materials, während die von der freien Fläche entfernten Bereiche des Substrats eine Temperatur oberhalb der minimalen Ausbildungstemperatur des Materials aufweisen.

2. Verfahren nach Anspruch 1, **dadurch gekennzeichnet, daß** die Temperatur der freiliegenden Fläche des Substrats, T_{S}, auf einem Wert gehalten wird, so daß T_{D}-50°C ≤ T_{S} ≤ T_{D}, wobei T_{D} die minimale Ausbildungstemperatur des Materials ist.

3. Verfahren nach Anspruch 1 oder 2 zur chemischen Dampfphasen-Infiltration von Pyrokohlenstoff aus einer Reaktions-Gasphase, die mindestens einen gesättigten oder ungesättigten Kohlenwasserstoff enthält, **dadurch gekennzeichnet, daß** man in die Kammer eine Reaktions-Gasphase einleitet, die außerdem Wasserstoff enthält, und man im Inneren des Substrats einen Wärmegradienten beiderseits einer Temperatur von 1230°C erzeugt.

4. Verfahren zum chemischen Infiltrieren von Material in das Innere eines porösen Substrats aus der Dampfphase, umfassend folgende Schritte:
- Anordnen des Substrats in einer Kammer,
- Erhitzen des Substrats durch Schaffung eines Wärmegradienten im Inneren des Substrats in der Weise, daß das Substrat in den von den freiliegenden Flächen entfernten Bereichen eine höhere Temperatur als an den freiliegenden Flächen aufweist, und
- Einleiten einer Reaktions-Vorläufer-Gasphase des zu infiltrierenden Materials in die Kammer, wobei die Ausbildung des Materials in den Bereichen höherer Temperatur des Substrats begünstigt wird,
**dadurch gekennzeichnet, daß**
- man ein Substrat aus elektrisch leitendem Material verwendet,
- man das Substrat durch direkte elektromagnetische Kopplung zwischen dem Substrat und einem Induktor erhitzt, und
- die Temperatur einer freiliegenden Fläche des Substrats gemessen wird, und
- man zu Beginn des Infiltrationsprozesses und während zumindest des größeren Teils des Prozesses einen Strom in dem Induktor in der Weise steuert, daß die Temperatur einer freiliegenden Fläche des Substrats geregelt wird, um sie auf einem Wert zu halten, der höchstens gleich ist der kleinsten Ausbildungstemperatur des aus der Reaktions-Gasphase zu infiltrierenden Materials, während die von der freiliegenden Fläche entfernten Bereiche des Substrats eine höhere als die minimale Ausbildungstemperatur des Materials aufweisen.

5. Verfahren nach Anspruch 4, **dadurch gekennzeichnet, daß** die Temperatur der freiliegenden Fläche des Substrats, T_{S}, auf einem Wert gehalten wird, so daß T_{D}-50°C ≤ T_{S} ≤ T_{D}, wobei T_{D} die minimale Ausbildungstemperatur des Materials ist.

6. Verfahren nach Anspruch 4 oder 5 zur chemischen Dampfphasen-Infiltration von Pyrokohlenstoff aus einer Reaktions-Gasphase, die mindestens einen gesättigten oder ungesättigten Kohlenwasserstoff enthält, **dadurch gekennzeichnet, daß** man in die Kammer eine Reaktions-Gasphase einleitet, die außerdem Wasserstoff enthält, und man im Inneren des Substrats einen Wärmegradienten beiderseits einer Temperatur von 1230°C erzeugt.

7. Verfahren nach einem der Ansprüche 4 bis 6, **dadurch gekennzeichnet, daß** man ein genadeltes Substrat aus Kohlenstoff oder Graphitfasern verwendet.

8. Verfahren nach Anspruch 7, **dadurch gekennzeichnet, daß** man in dem Induktor einen Strom mit einer Frequenz zwischen 100 Hz und 3000 Hz fließen läßt.

## Claims

1. A method for the chemical vapour infiltration of a material into a porous substrate, the method comprising the steps consisting in:
placing the substrate in an enclosure with a surface of the substrate in contact with a core;
heating the substrate by circulation of a current in an induction winding that is coupled electromagnetically with the core, such that a temperature gradient is established within the substrate between its surface in contact with the core and an exposed surface; and
admitting into the enclosure a reaction gas that constitutes a precursor for the material to be infiltrated, formation of the material being enhanced in the higher-temperature portions of the substrate;
the method being **characterised in that**:
the temperature of an exposed surface of the substrate is measured; and
at the beginning of the infiltration process and at least during the major portion thereof, the current in the induction winding is controlled in such a manner as to regulate the temperature of the exposed surface of the substrate so as to maintain it at a value that is no greater than the minimum temperature for the reaction gas to form the material that is to be infiltrated, while the portions of the substrate that are remote from the exposed surface are at a temperature that is greater than the minimum temperature for forming the material.

2. A method according to claim 1, **characterised in that** the temperature T_{S} of the exposed surface of the substrate is maintained at a value such that
T_{D} - 50°C ≤ T_{S} ≤ T_{D}, where T_{D} is the minimum temperature for forming the material.

3. A method according to any one of claims 1 and 2, for the chemical vapour infiltration of pyrolytic carbon from a reaction gas containing at least one saturated or unsaturated hydrocarbon, the method being **characterised in that** a reaction gas further containing hydrogen is admitted into the enclosure and a temperature gradient is established within the substrate on either side of a temperature of 1230°C.

4. A method for the chemical vapour infiltration of a material into a porous substrate, the method comprising the steps consisting in:
placing the substrate in an enclosure;
heating the substrate so as to establish therein a temperature gradient such that the substrate has a higher temperature in portions that are more remote from its exposed surfaces than it has at said surfaces; and
admitting into the enclosure a reaction gas that constitutes a precursor for the material to be infiltrated, formation of the material being enhanced in the higher-temperature portions of the substrate;
the method being **characterised in that**:
the substrate used is a substrate made of an electrically conductive material;
the substrate is heated by direct electromagnetic coupling between the substrate and the induction winding;
the temperature of an exposed surface of the substrate is measured; and
at the beginning of the infiltration process and at least during the major portion thereof, a current in the induction winding is controlled in such a manner as to regulate the temperature of an exposed surface of the substrate so as to maintain it at a value that is no greater than the minimum temperature for the reaction gas to form the material that is to be infiltrated, while the portions of the substrate that are remote from the exposed surface are at a temperature that is greater than the minimum temperature for forming the material.

5. A method according to claim 4, **characterised in that** the temperature T_{S} of the exposed surface of the substrate is maintained at a value such that
T_{D} - 50°C ≤ T_{S} ≤ T_{D}, where T_{D} is the minimum temperature for forming the material.

6. A method according to any one of claims 4 and 5, for the chemical vapour infiltration of pyrolytic carbon from a reaction gas containing at least one saturated or unsaturated hydrocarbon, the method being **characterised in that** a reaction gas further containing hydrogen is admitted into the enclosure and a temperature gradient is established within the substrate on either side of a temperature of 1230°C.

7. A method according to any one of claims 4 to 6, **characterised in that** a needled substrate of carbon or graphite fibres is used.

8. A method according to claim 7, **characterised in that** a current whose frequency lies in the range 100 Hz to 3000 Hz is circulated in the induction winding.
